# EUROPEAN PATENT APPLICATION

(11) **EP 4 503 260 A1**
(43) Date of publication of application: **05.02.2025**
(21) Application number: 23826720.7
(22) Date of filing: 21.02.2023
(51) Int. Cl.: H01M 10/48, B60L 3/00, H02J 7/10

(54) **HYBRID SYSTEM**

(30) Priority: 21.06.2022 JP 2022099519
(71) Applicant: Kubota Corporation, Osaka 556-8601 (JP)
(72) Inventor: FUJII, Yasuo, Sakai-shi, Osaka 592-8331 (JP); KOYAMA, Kazuaki, Sakai-shi, Osaka 592-8331 (JP); HORITA, Tatsuhiko, Sakai-shi, Osaka 592-8331 (JP); NAGAMORI, Yuko, Sakai-shi, Osaka 592-8331 (JP); KIMURA, Ryota, Sakai-shi, Osaka 592-8331 (JP)
(74) Representative: Mewburn Ellis LLP
(86) International application number: PCT/JP2023/006219
(87) International publication number: WO 2023/248531

(57) **Abstract**

[Problem] To provide a hybrid system which can detect and store a temperature of a battery that supplies electric power to a motor at the time of storage, while power consumption of the battery that supplies the electric power to an ECU is suppressed.

[Solution] A hybrid system 10 is a hybrid system mounted on an industrial machine and has a motor 2, a battery 50 that supplies electric power to the motor 2, and a storage portion 151 and also includes a control portion 150 that executes such control that detects a temperature of the battery 50, when an ignition switch of the industrial machine is turned on, and stores the temperature at the detection as a temperature of the industrial machine at the time of storage in the storage portion 151.

## Description

### [Technical Field]

The present invention relates to a hybrid system mounted on an industrial machine.

### [Background Art]

A hybrid system that concurrently uses an engine, a motor, and a battery has been developed for industrial machines, automobiles and the like in response to a request for lower pollution and resource saving of fossil fuel. The hybrid system includes, for example, an internal combustion engine that generates power by using the fossil fuel, a motor that assists the internal combustion engine, and a battery such as a lithium-ion battery or the like, for example, that supplies electric power to the motor.

In the hybrid system, a battery pack including the lithium-ion battery, for example, is used as a power supply for driving the motor. In the lithium-ion battery, such a degradation phenomenon occurs that a full-charge capacity is decreased by storage for a long time or a use for a long time. Thus, PTL 1 discloses a measuring method of a side-reaction electric-current value of a secondary cell, a life estimating method, and an inspecting method that estimates a life of the secondary cell more accurately and can inspect propriety of shipment on the basis thereof.

For example, automobile manufacturers uniquely guarantee against degradation of lithium-ion batteries for automobiles such as passenger cars having the hybrid system. As the guarantee against degradation of the lithium-ion batteries, for example, such a guarantee that the lithium-ion battery is replaced for free in the case where degradation at a reference value or more occurs in the lithium-ion battery, when a period of use is within 5 years or a traveled distance is within 100,000 km can be cited.

From the viewpoint of safety and life, use of a lithium-ion battery under a high temperature environment is not recommended. Thus, as an example of a guarantee condition for the lithium-ion battery, use of the lithium-ion battery at a certain temperature or below can be cited. Here, in the automobile such as a passenger car or the like, not only during operation of the automobile but also while the power is off (that is, an ignition switch is off), an ECU (Engine Control Unit) is regularly activated and detects and stores the temperature of the lithium-ion battery at the time of storage of the automobile in some cases. In this case, an automobile manufacturer can make guarantee negotiation on the basis of the temperature data at the time of storage of the automobile.

However, there is such a problem that a storage period of an industrial machine might be longer than the storage period of an automobile in some cases. That is, if the storage period of an industrial machine is relatively long, a battery (a lead storage battery, for example) that supplies electric power to the ECU might be removed from the industrial machine at the time of storage depending on a user of the industrial machine. Then, since the ECU cannot receive supply of the electric power, the ECU cannot be activated while power is off and cannot detect and store the temperature of the lithium-ion battery at the time of storage of the industrial machine.

Moreover, even in a state where the battery that supplies electric power to the ECU remains attached to the industrial machine at the time of storage, there is such a problem that electric power caused by a dark current for activating the ECU, when the power is off, is consumed in the battery (a lead storage battery, for example). That is, if the storage period of the industrial machine is relatively long, the magnitude of the power consumption of the battery (a lead storage battery, for example) caused by the dark current cannot be ignored, and the power consumption of the battery (a lead storage battery, for example), when the power is off, is one of important problems.

### [Citation List]

### [Patent Literature]

[PTL 1] Japanese Patent Application Publication No. 2021-131344

### [Summary of Invention]

### [Technical Problem]

The present invention was made in view of the aforementioned circumstances and has an object to provide a hybrid system capable of detecting and storing a temperature at the time of storage of a battery that supplies electric power to a motor, while power consumption of the battery that supplies electric power to an ECU is suppressed.

### [Solution to Problem]

A first aspect of the present invention is a hybrid system mounted on an industrial machine, characterized by including a motor, a battery that supplies electric power to the motor, and a control portion having a storage portion and executing control that detects a temperature of the battery, when an ignition switch of the industrial machine is turned on and stores the temperature at the detection as a temperature of the industrial machine at the time of storage in the storage portion.

According to the first aspect of the present invention, the control portion detects a temperature of the battery, when the ignition switch of the industrial machine is turned on and stores the temperature at the detection as the temperature of the industrial machine at the time of storage in the storage portion, even if the control portion is not activated when the power is off (that is, the ignition switch of the industrial machine is off). Thus, the hybrid system according to the first aspect of the present invention can detect and store the temperature at the time of storage of the battery (a lithium-ion battery, for example) that supplies electric power to the motor, while power consumption of the battery (a lead storage battery, for example) that supplies electric power to the control portion such as the ECU is suppressed. As a result, the hybrid system according to the first aspect of the present invention can detect and store the temperature of the battery at the time of storage of the industrial machine in relation with degradation of the battery that supplies the electric power to the motor, whereby temperature data at the time of storage which can be effectively used for guarantee negotiation of the battery can be obtained.

A second aspect of the present invention is, in the first aspect of the present invention, a hybrid system characterized in that the control portion executes control that elapsed time from when the ignition switch was turned off the previous time till when it is turned on this time is measured and, when the elapsed time is predetermined time or longer, a temperature at the detection is stored in the storage portion as a temperature at the time of the storage.

According to the second aspect of the present invention, in the case where the elapsed time from when the ignition switch was turned off the previous time till when it is turned on this time is the predetermined time or longer, the control portion stores the temperature of the battery, when the ignition switch was turned on, as the temperature of the industrial machine at the time of the storage in the storage portion and thus, storing of the temperature of the battery, when the ignition switch is turned on again immediately after it was turned off, for example, as the temperature of the industrial machine at the time of storage in the storage portion can be suppressed. That is, the control portion can suppress storage of a temperature, which is inappropriate as the temperature of the industrial machine at the time of the storage, in the storage portion. As a result, the hybrid system according to the second aspect of the present invention can obtain temperature data at the time of the storage which can be used further effectively for guarantee negotiation of the battery.

A third aspect of the present invention is, in the first aspect or the second aspect of the present invention, a hybrid system characterized in that the control portion executes control that, after the ignition switch was turned on, a temperature of the battery is detected at every predetermined time during operation of the industrial machine and the temperature at every predetermined time is further stored in the storage portion.

According to the third aspect of the present invention, the control portion stores both the temperature of the battery of the industrial machine at the time of storage and the temperature of the battery during operation of the industrial machine in the storage portion. Thus, the hybrid system according to the third aspect of the present invention can grasp whether or not a user of the industrial machine is using the battery at an abnormal temperature more reliably. As a result, the hybrid system according to the third aspect of the present invention can obtain the temperature data at the time of the storage and during the operation that can be used further effectively for the guarantee negotiation of the battery.

A fourth aspect of the present invention is, in any one of the first aspect to the third aspect of the present invention, a hybrid system characterized in that the storage portion stores weather data of a place where the industrial machine is used, and the control portion executes such control that corrects a temperature at the detection in accordance with at least any one of time, date and month when the ignition switch was turned on by using the weather data and stores the corrected temperature in the storage portion as the temperature at the time of the storage instead of the temperature at the detection.

According to the fourth aspect of the present invention, the control portion corrects the temperature of the battery, when the ignition switch was turned on, in accordance with at least any one of the time, date, and month by using the weather data. And the control portion stores the corrected temperature in the storage portion as the temperature of the industrial machine at the time of the storage instead of a temperature of the battery when the ignition switch was turned on. Thus, the control portion can store the temperature of the battery at the time of the storage of the industrial machine with higher accuracy in the storage portion, while an influence of time, date, and month when the ignition switch of the industrial machine was turned on is suppressed. As a result, the hybrid system according to the fourth aspect of the present invention can obtain the temperature data at the time of the storage which can be used further effectively for the guarantee negotiation of the battery.

### [Advantageous Effects of Invention]

According to the present invention, such a hybrid system can be provided that can detect and store a temperature at the time of storage of a battery that supplies electric power to a motor, while power consumption of the battery that supplies electric power to an ECU is suppressed.

### [Brief Description of Drawings]

[Fig. 1]

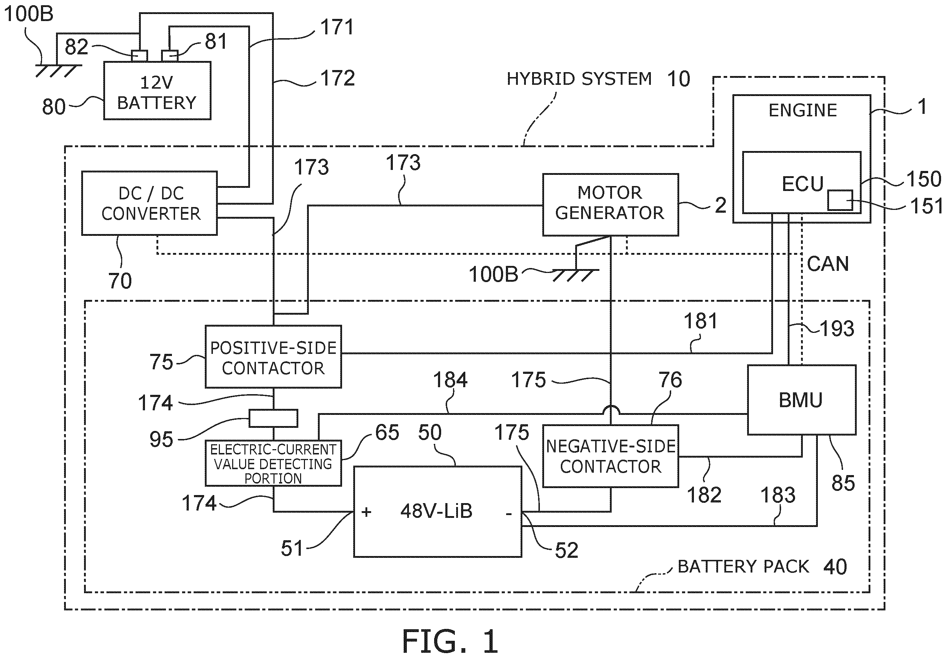

   Fig. 1 is a block diagram illustrating a hybrid system according to an embodiment of the present invention.
[Fig. 2]

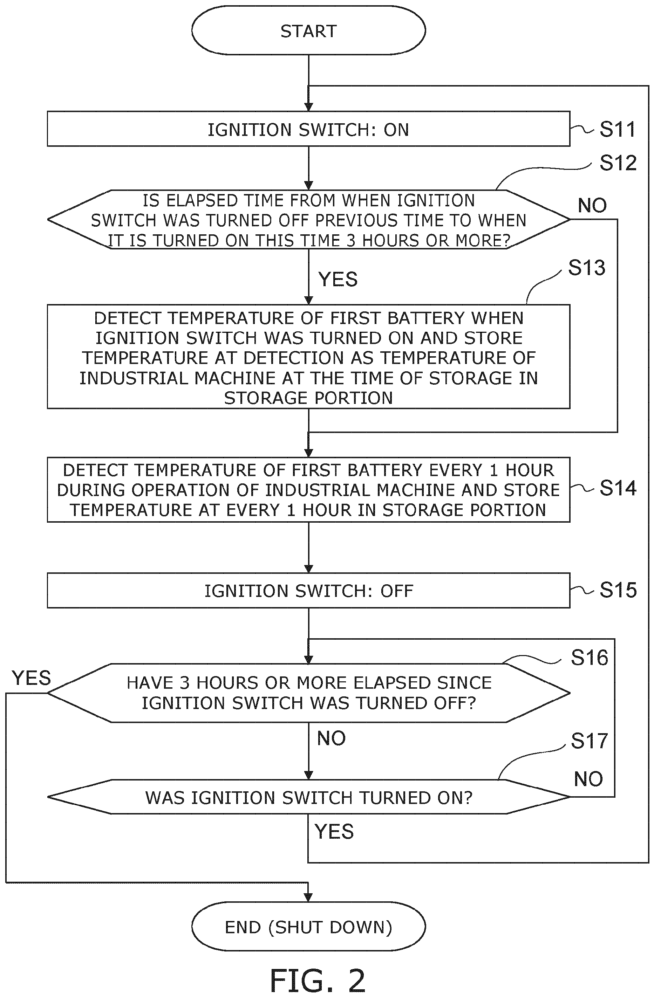

   Fig. 2 is a flowchart illustrating a first specific example of an operation of the hybrid system according to this embodiment.
[Fig. 3]

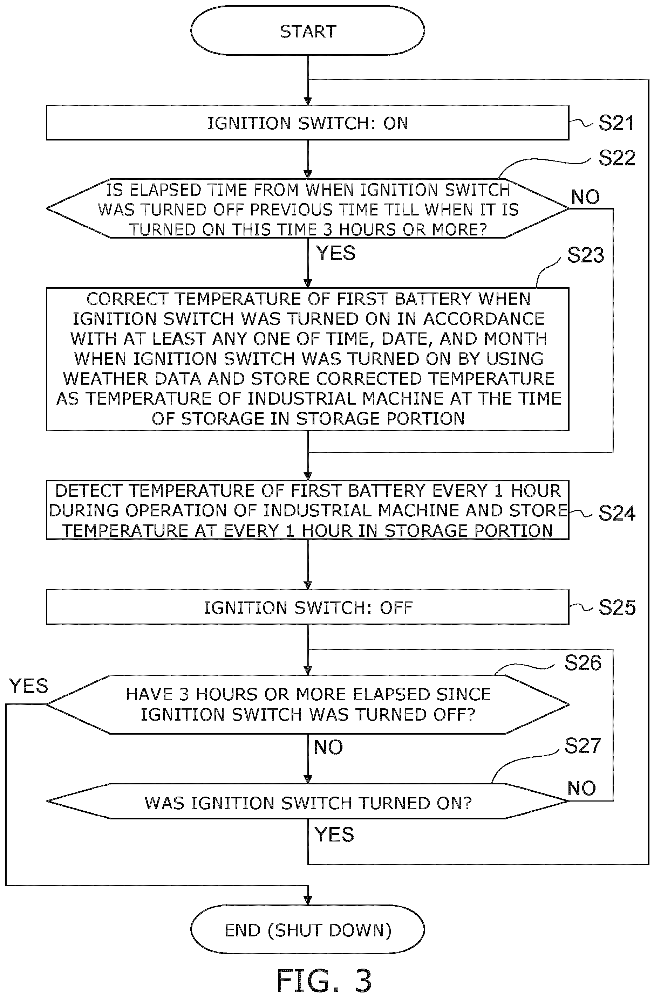

   Fig. 3 is a flowchart illustrating a second specific example of an operation of the hybrid system according to this embodiment.

### [Description of Embodiments]

Hereinafter, an embodiment of the present invention will be explained with reference to the drawings.

Note that the embodiment explained below is a preferred embodiment of the present invention and thus, technically preferable various limitations are given, but a scope of the present invention is not limited to these aspects unless there is a description that limits the present invention in particular in the following explanation. Moreover, in each of the drawings, the same signs are given to the same constituent elements, and detailed explanation will be omitted as appropriate.

Fig. 1 is a block diagram illustrating a hybrid system according to the embodiment of the present invention.

The hybrid system 10 shown in Fig. 1 includes an engine 1, a motor generator 2, and a battery pack 40. The motor generator 2 of this embodiment is an example of the "motor" of the present invention. The hybrid system 10 further includes a DC / DC converter 70.

The engine 1 is a multi-cylinder diesel engine such as a supercharging-type high-output 3-cylinder engine having a turbocharger, a 4-cylinder engine or the like, for example. However, the engine 1 is not limited to the diesel engine. The engine 1 has an ECU (Engine Control Unit) 150. The ECU 150 of this embodiment is an example of a "control portion" of the present invention. The ECU 150 controls an operation of the engine 1 and controls the motor generator 2 and the DC / DC converter 70 by performing communication with the motor generator 2 and the DC / DC converter 70 by a CAN (Controller Area Network), for example. Moreover, the ECU 150 has a storage portion 151.

The motor generator 2 is operated by electric power supplied from the battery pack 40 and supports the engine 1, when power is required such as at start or at acceleration of an industrial machine or the like on which the hybrid system 10 is mounted. Note that the hybrid system 10 is mounted on the industrial machine including a construction machine such as a forklift or the like and an agricultural machine such as a tractor, for example. Moreover, the motor generator 2 generates power by converting kinetic energy of an industrial machine on which the hybrid system 10 is mounted or the like to electric energy using a regenerative brake or the like. The motor generator 2 incorporates an inverter. However, the inverter does not necessarily have to be incorporated in the motor generator 2 but may be provided as a body separated from the motor generator 2.

The battery pack 40 has a first battery 50, a positive-side contactor 75, a negative-side contactor 76, an electric-current value detecting portion 65, a BMU (Battery Management Unit) 85, and a fuse 95. The first battery 50 is provided as a drive power-supply of the motor generator 2 and supplies electric power to the motor generator 2. The first battery 50 has a positive terminal 51 and a negative terminal 52. As the first battery 50, a high-voltage type lithium-ion battery (LiB) of 48 V can be cited, for example. However, the first battery 50 is not limited to the lithium-ion battery. Moreover, the voltage of the first battery 50 is not limited to 48 V but may be equal to or higher than 48 V. The first battery 50 of this embodiment is an example of a "battery" of the present invention.

The positive-side contactor 75 is provided at the electric circuit between the positive terminal 51 of the first battery 50 and the motor generator 2. Specifically, as shown in Fig. 1, the positive-side contactor 75 is provided at positive wirings 173, 174 connecting the positive terminal 51 of the first battery 50 and the motor generator 2. That is, the electric circuit between the positive terminal 51 of the first battery 50 and the motor generator 2 includes the positive wiring 173 and the positive wiring 174. The positive-side contactor 75 is electrically connected to the ECU 150 by a signal line 181 and performs opening / closing of the positive wirings 173, 174 on the basis of a control signal transmitted from the ECU 150 via the signal line 181.

Note that the positive-side contactor 75 may be electrically connected to the BMU 85. In this case, the positive-side contactor 75 performs opening / closing of the positive wirings 173, 174 on the basis of the control signal transmitted from the BMU 85.

The negative-side contactor 76 is provided at the electric circuit between the negative terminal 52 of the first battery 50 and the motor generator 2. Specifically, as shown in Fig. 1, the negative-side contactor 76 is provided at a negative wiring 175 connecting the negative terminal 52 of the first battery 50 and the motor generator 2. That is, the electric circuit between the negative terminal 52 of the first battery 50 and the motor generator 2 includes the negative wiring 175. The negative-side contactor 76 is electrically connected to the BMU 85 by a signal line 182 and performs opening / closing of the negative wiring 175 on the basis of the control signal transmitted from the BMU 85 via the signal line 182.

Note that the negative-side contactor 76 may be electrically connected to the ECU 150. In this case, the negative-side contactor 76 performs opening / closing of the negative wiring 175 on the basis of the control signal transmitted from the ECU 150.

The BMU 85 is electrically connected to the ECU 150 by a signal line 193 and controls the negative-side contactor 76 on the basis of a control signal transmitted from the ECU 150 via the signal line 193. The ECU 150 and the BMU 85 communicate with each other and mutually monitor the state of the other by the CAN, for example.

The BMU 85 is electrically connected to the first battery 50 by a signal line 183 and detects a voltage value of the first battery 50 on the basis of the signal transmitted from the first battery 50 via the signal line 183. Specifically, the BMU 85 detects a voltage value of the respective cell incorporated in the first battery 50 by using an internal circuit incorporated in the BMU 85 itself and detects the total sum of the voltage values of the respective cells as a voltage value of the first battery 50. And the BMU 85 transmits the voltage value of the first battery 50 detected by the internal circuit to the ECU 150.

The BMU 85 monitors the state of the first battery 50 and can detect an abnormality of the first battery 50 on the basis of a signal transmitted from the first battery 50 via the signal line 183. For example, the BMU 85 detects a voltage value of the first battery 50 on the basis of the signal transmitted from the first battery 50 via the signal line 183 and detects an overcharge abnormality and an over-discharge abnormality.

The BMU 85 obtains a cell temperature of the first battery 50 from a CMU (Cell Management Unit; not shown) via the signal line 183. The BMU 85 communicates with the ECU 150 by the CAN, and transmits the obtained cell temperature of the first battery 50 to the ECU 150. As a result, the ECU 150 can detect the cell temperature of the first battery 50. The BMU 85 detects an over-temperature abnormality on the basis of the cell temperature obtained from the CMU.

The BMU 85 is electrically connected to the electric-current value detecting portion 65 by a signal line 184 and obtains the electric-current value from the electric-current value detecting portion 65 via the signal line 184. The electric-current value detecting portion 65 is provided at the positive wiring 174 and detects an electric-current value flowing through the positive wiring 174. That is, the BMU 85 obtains the electric-current value flowing through the positive wiring 174 from the electric-current value detecting portion 65 via the signal line 184. The BMU 85 detects the over-current abnormality on the basis of the electric-current value obtained from the electric-current value detecting portion 65 via the signal line 184.

The fuse 95 is provided at the positive wiring 174 between the electric-current value detecting portion 65 and the positive-side contactor 75. The fuse 95 shuts down the electric circuit, that is, the positive wiring 174, when an over-current flows through the positive wiring 174.

As described above, the negative wiring 175 electrically connects the negative terminal 52 of the first battery 50 and the motor generator 2 and becomes a ground 100B. For example, the negative wiring 175 is connected to a body of the industrial machine or the like on which the hybrid system 10 is mounted and grounded. The positive wiring 173 electrically connects the positive terminal 51 of the first battery 50 and the motor generator 2 and electrically connects the motor generator 2 and the DC / DC converter 70. As in the hybrid system 10 shown in Fig. 1, when the first battery 50 is a lithium-ion battery of 48 V, potentials of the positive wirings 173, 174 to the negative wiring 175 are 48 V.

The DC / DC converter 70 is electrically connected to a second battery 80 via a positive wiring 171 and a negative wiring 172. The negative wiring 172 electrically connects a negative terminal 82 of the second battery 80 and the DC / DC converter 70 and becomes a ground 100B. For example, the negative wiring 172 is connected to the body of the industrial machine or the like on which the hybrid system 10 is mounted and grounded. The positive wiring 171 electrically connects the positive terminal 81 of the second battery 80 and the DC / DC converter 70. As in the hybrid system 10 shown in Fig. 1, when the second battery 80 is a lead storage battery of 12 V, a potential of the positive wiring 171 to the negative wiring 172 is 12 V. The second battery 20 supplies electric power to the ECU 150.

The DC / DC converter 70 detects a voltage value of the second battery 80 by using an internal circuit incorporated in the DC / DC converter 70 itself. And the DC / DC converter 70 transmits the voltage value of the second battery 80 detected by the internal circuit to the ECU 150.

As described above, the motor generator 2 generates power by converting kinetic energy of an industrial machine on which the hybrid system 10 is mounted or the like to electric energy using a regenerative brake or the like. And the motor generator 2 supplies the voltage to the first battery 50 so as to charge the first battery 50 and supplies the voltage to the second battery 80 so as to charge the second battery 80. Here, by citing the hybrid system 10 shown in Fig. 1 as an example, the potential of the positive wiring 173 to the negative wiring 175 is 48 V. That is, the power-generation voltage of the motor generator 2 is 48 V. On the other hand, the potential of the positive wiring 171 to the negative wiring 172 is 12 V. Thus, the DC / DC converter 70 converts the voltage of 48 V generated by the motor generator 2 to the voltage of 12 V. As a result, the motor generator 2 can supply the voltage of 12 V to the second battery 80 via the DC / DC converter 70 so as to charge the second battery 80.

Moreover, the DC / DC converter 70 is electrically connected to the first battery 50 and the second battery 80 and can perform charging and discharging between the first battery 50 and the second battery 80 on the basis of a control signal transmitted from the ECU 150. For example, the DC / DC converter 70 can discharge the first battery 50 and charge the second battery 80 by converting the voltage and by causing a constant electric current (10A, for example) to flow from the first battery 50 toward the second battery 80. Alternatively, for example, the DC / DC converter 70 can discharge the second battery 80 and charge the first battery 50 by converting the voltage and causing the constant electric current (10A, for example) to flow from the second battery 80 toward the first battery 50.

Here, from a viewpoint of safety and life, use of the first battery 50 (a lithium-ion battery or the like, for example) under a high temperature environment is not recommended. Thus, as an example of a guarantee condition for the first battery 50, use of the first battery 50 at a certain temperature or below can be cited. At this time, a storage period of an industrial machine on which the hybrid system 10 is mounted makes a problem in some cases. That is, if the storage period of the industrial machine on which the hybrid system 10 is mounted is relatively long, the second battery 80 that supplies electric power to the ECU 150 might be removed from the industrial machine by a user of the industrial machine at the time of the storage in some cases. Then, since the ECU 150 cannot receive the supply of electric power, the ECU 150 cannot be activated when the power is turned off (that is, the ignition switch of the industrial machine is off) and cannot detect and store the temperature of the first battery 50 at the time of the storage of the industrial machine.

Moreover, even in a state where the second battery 80 remains attached to the industrial machine at the time of the storage of the industrial machine, there is such a problem that the electric power caused by a dark current for activating the ECU 150, when the power is off, is consumed in the second battery 80. That is, if the storage period of the industrial machine is relatively long, the magnitude of the power consumption of the second battery 80 caused by the dark current cannot be ignored, and the power consumption of the second battery 80, when the power is off, is one of important problems.

On the other hand, the ECU 150 of the hybrid system 10 according to this embodiment executes such control that detects a temperature of the first battery 50 when the ignition switch of the industrial machine on which the hybrid system 10 is mounted is turned on and stores the temperature at the detection as a temperature of the industrial machine at the time of the storage in the storage portion 151. Specifically, when the ignition switch of the industrial machine on which the hybrid system 10 is mounted is turned on, the ECU 150 communicates with the BMU 85 by the CAN and obtains a cell temperature of the first battery 50 obtained by the BMU 85. And the ECU 150 stores the cell temperature of the first battery 50 obtained by the CAN from the BMU 85 as the temperature of the industrial machine at the time of the storage in the storage portion 151.

According to the hybrid system 10 according to this embodiment, even if the ECU 150 is not activated when the power is off (that is, the ignition switch of the industrial machine is off), the ECU 150 detects the temperature of the first battery 50 when the ignition switch of the industrial machine is turned on and stores the temperature at the detection as a temperature of the industrial machine at the time of the storage in the storage portion 151. Thus, the hybrid system 10 can detect and store the temperature of the first battery 50 at the time of the storage of the industrial machine, while suppressing power consumption of the second battery 80. As a result, the hybrid system 10 according to this embodiment can, in relation with the degradation of the first battery 50, detect and store the temperature of the first battery 50 at the time of the storage of the industrial machine and can obtain the temperature data at the time of the storage that can be effectively used for the guarantee negotiation of the first battery 50.

Hereinafter, a specific example of an operation of the hybrid system 10 according to this embodiment will be explained in detail with reference to the drawings.

Fig. 2 is a flowchart illustrating a first specific example of the operation of the hybrid system according to this embodiment.

First, at Step S11, a user or the like of the industrial machine on which the hybrid system 10 is mounted pushes a starter key for activating the hybrid system 10 so as to turn on the ignition switch of the industrial machine. Then, at Step S12, the ECU 150 measures an elapsed time from when the ignition switch was turned off the previous time till when it is turned on this time and determines whether or not the elapsed time is predetermined time or longer. At Step S12 shown in Fig. 2, the "predetermined time" is 3 hours. However, the "predetermined time" related to Step S12 is not limited to 3 hours and it may be approximately 1 hour or more, 5 hours or less, for example.

If the elapsed time from when the ignition switch was turned off the previous time till when it is turned on this time is 3 hours or more (Step S12: YES), at Step S13, the ECU 150 detects a temperature of the first battery 50 when the ignition switch was turned on and stores the temperature at the detection as a temperature of the industrial machine at the time of storage in the storage portion 151.

On the other hand, if the elapsed time from when the ignition switch was turned off the previous time till when it is turned on this time is less than 3 hours (Step S12: NO), at Step S14 subsequent to Step S12, the ECU 150 does not store the temperature of the first battery 50 when the ignition switch was turned on in the storage portion 151 but detects the temperature of the first battery 50 at every predetermined time during operation of the industrial machine and stores the temperature at every predetermined time in the storage portion 151. At Step S14 shown in Fig. 2, the "predetermined time" is 1 hour. However, the "predetermined time" related to Step S14 is not limited to 1 hour but may be approximately 1 hour or more, 3 hours or less, for example.

At Step S14 subsequent to Step S13, the ECU 150 executes processing similar to the processing described above in relation with Step S14.

Subsequently, at Step S15, the user or the like of the industrial machine on which the hybrid system 10 is mounted turns off the ignition switch of the industrial machine. Then, at Step S16, the ECU 150 measures the elapsed time since the ignition switch was turned off and determines whether or not the elapsed time is the predetermined time or longer. The "predetermined time" related to Step S16 is similar to the "predetermined time" described above in relation with Step S12.

If the elapsed time since the ignition switch was turned off is 3 hours or more (Step S16: YES), the ECU 150 ends (shuts down) the operation of the hybrid system 10.

On the other hand, if the elapsed time since the ignition switch was turned off is less than 3 hours (Step S16: NO), at Step S17, the ECU 150 determines whether or not the ignition switch has been turned on. If the ignition switch has been turned on (Step S17: YES), the ECU 150 executes the processing described in relation with Step S11. On the other hand, if the ignition switch has not been turned on (Step S17: NO), the ECU 150 executes the processing described in relation with Step S16.

According to this specific example, if the elapsed time from when the ignition switch was turned off the previous time till when it is turned on this time is the predetermined time or longer, the ECU 150 stores the temperature of the first battery 50 when the ignition switch was turned on as the temperature of the industrial machine at the time of the storage in the storage portion 151 and thus, the ECU 150 can suppress such storing of the temperature of the first battery 50 when the ignition switch was turned on again immediately after the ignition switch was turned off as the temperature of the industrial machine at the time of the storage in the storage portion 151. That is, the ECU 150 can suppress the storing of an inappropriate temperature as the temperature of the industrial machine at the time of the storage in the storage portion 151. As a result, the hybrid system 10 according to this embodiment can obtain the temperature data at the time of the storage that can be used further effectively for the guarantee negotiation of the first battery 50.

Moreover, at Step S14, the ECU 150 stores the temperature of the first battery 50 at every predetermined time during the operation of the industrial machine in the storage portion 151. Thus, the ECU 150 can store both the temperature of the first battery 50 of the industrial machine at the time of the storage and the temperature of the first battery 50 during the operation of the industrial machine in the storage portion 151. Thus, the hybrid system 10 according to this embodiment can grasp whether or not the user of the industrial machine is using the first battery 50 at an abnormal temperature further reliably. As a result, the hybrid system 10 according to this embodiment can obtain the temperature data at the time of the storage and during the operation that can be used further effectively for the guarantee negotiation of the first battery 50.

Fig. 3 is a flowchart illustrating a second specific example of the operation of the hybrid system according to this embodiment.

In the second specific example, Step S13 described above in relation with Fig. 2 is replaced with Step S23 shown in Fig. 3. The other steps are similar to the steps described above in relation with Fig. 2. That is, processing executed at Steps S21 to S22, S24 to S27 shown in Fig. 3 is similar to the processing at Steps S11 to S12, S14 to S17 described above in relation with Fig. 2. Thus, in this specific example, Step S23 will be mainly explained, while explanation on Steps S21 to S22, S24 to S27 will be omitted as appropriate.

First, in the hybrid system 10 of this specific example, the storage portion 151 stores weather data of a place where the industrial machine on which the hybrid system 10 is mounted is used. As the weather data, a temperature, a humidity, a wind direction, a wind velocity, duration of sunshine and the like at the place where the industrial machine on which the hybrid system 10 is mounted is used can be cited.

If the elapsed time from when the ignition switch was turned off the previous time till when it is turned on this time is 3 hours or more (Step S22: YES), at Step S23, the ECU 150 corrects the temperature when the ignition switch was turned on by using the weather data in accordance with at least any one of time, date, and month when the ignition switch was turned on and stores the corrected temperature as the temperature of the industrial machine at the time of the storage in the storage portion 151.

According to this specific example, the ECU 150 can store the temperature of the first battery 50 at the time of the storage of the industrial machine with higher accuracy in the storage portion 151, while an influence by the time, date, and month when the ignition switch of the industrial machine was turned on. As a result, the hybrid system 10 according to this embodiment can obtain the temperature data at the time of the storage that can be used further effectively for the guarantee negotiation of the first battery 50.

As described above, the embodiment of the present invention has been explained. However, the present invention is not limited to the aforementioned embodiment but is capable of various changes within a range not departing from the scope of claims. The configuration of the aforementioned embodiment can be partially omitted or arbitrarily combined differently from the above.

### [Reference Signs List]

- 1: Engine
- 2: Motor generator
- 10: Hybrid system
- 20: Second battery
- 40: Battery pack
- 50: First battery
- 51: Positive terminal
- 52: Negative terminal
- 65: Electric-current value detecting portion
- 70: DC / DC converter
- 75: Positive-side contactor
- 76: Negative-side contactor
- 80: Second battery
- 81: Positive terminal
- 82: Negative terminal
- 85: BMU
- 95: Fuse
- 100B: Ground
- 150: ECU
- 151: Storage portion
- 171: Positive wiring
- 172: Negative wiring
- 173: Positive wiring
- 174: Positive wiring
- 175: Negative wiring
- 181: Signal line
- 182: Signal line
- 183: Signal line
- 184: Signal line
- 193: Signal line

## Claims

1. A hybrid system mounted on an industrial machine, comprising:
a motor;
a battery that supplies electric power to the motor; and
a control portion that has a storage portion and executes control that detects a temperature of the battery, when an ignition switch of the industrial machine was turned on, and stores the temperature at the detection as a temperature at the time of storage of the industrial machine in the storage portion.

2. The hybrid system according to claim 1, wherein
the control portion executes control that measures elapsed time from when the ignition switch was turned off the previous time till when the ignition switch is turned on this time and, if the elapsed time is predetermined time or longer, stores the temperature at the detection as a temperature at the time of the storage in the storage portion.

3. The hybrid system according to claim 1, wherein
the control portion executes control that detects a temperature of the battery at every predetermined time during an operation of the industrial machine after the ignition switch was turned on and further stores the temperature at every predetermined time in the storage portion.

4. The hybrid system according to claim 1, wherein
the storage portion stores weather data of a place where the industrial machine is used; and
the control portion executes control that corrects the temperature at the detection in accordance with at least any one of time, date, and month when the ignition switch was turned on by using the weather data and stores the corrected temperature as a temperature at the time of the storage instead of the temperature at the detection in the storage portion.
